# EUROPEAN PATENT SPECIFICATION

(11) **EP 3 971 990 B1**
(45) Date of publication and mention of the grant of the patent: **13.12.2023**
(21) Application number: 21784007.3
(22) Date of filing: 08.03.2021
(51) Int. Cl.: H01L 29/51, H01L 21/70, H10B 12/00

(54) **SEMICONDUCTOR STRUCTURE AND METHOD FOR MANUFACTURING SAME**
HALBLEITERSTRUKTUR UND VERFAHREN ZUR HERSTELLUNG DAVON
STRUCTURE SEMI-CONDUCTRICE ET SON PROCÉDÉ DE FABRICATION

(30) Priority: 07.04.2020 CN 202010264790
(43) Date of publication of application: 23.03.2022
(73) Proprietor: Changxin Memory Technologies, Inc., Hefei City, Anhui 230000 (CN)
(72) Inventor: PING, Er-Xuan, Hefei City, Anhui 230000 (CN); ZHOU, Zhen, Hefei City, Anhui 230000 (CN)
(74) Representative: V.O.
(86) International application number: PCT/CN2021/079547
(87) International publication number: WO 2021/203886

(56) References cited:
- CN-A- 1 571 143
- CN-A- 101 002 330
- CN-A- 104 600 075
- US-A1- 2002 079 527
- US-A1- 2003 169 133
- US-A1- 2011 068 386
- US-A1- 2012 235 229

## Description

### FILED OF THE INVENTION

The present invention relates to the field of semiconductor technology, in particular to a semiconductor structure and a method of manufacturing the same.

### BACKGROUND OF THE INVENTION

In the existing semiconductor process, in order to solve the problem of gate-induced drain leakage current, a dual work-function gate evolves as the mainstream of the buried word line, wherein the dual work-function gate includes a first conductive layer and a second conductive layer stacked on the first conductive layer. However, in the manufacture procedure of the dual work-function gate, the conductive materials in the first conductive layer have a problem of diffusing into the second conductive layer. For example, in the case where the first conductive layer is a metal layer and the second conductive layer is a polycrystalline silicon layer, the metal in the metal layer diffuses more significantly into the polycrystalline silicon layer after experiencing a thermal process, resulting in a problem of affecting the performance of the polycrystalline silicon layer.

US2002/079527A1 relates to a DRAM cell configuration, i.e. a dynamic random access memory cell configuration, in which bit lines are buried in a substrate, and to a method of fabricating the DRAM cell configuration.

US2012/235229A1 relates to an inter-poly dielectric of a mental-oxide-semiconductor field-effect transistor device. An apparatus can include a shield dielectric disposed within a trench aligned along an axis within an epitaxial layer of a semiconductor, and a shield electrode disposed within the shield dielectric and aligned along the axis.

US2011/068386A1 relates to a semiconductor device and more particularly to trench-gate field effect transistors and a method for making a semiconductor device.

### SUMMARY OF THE INVENTION

A semiconductor structure and a method of manufacturing the same are provided to prevent the conductive materials in a first conductive layer from diffusing into a second conductive layer, and improve the performance of the device. The invention is set out in the appended set of claims. Any embodiment in the present disclosure that does not fall within the scope of protection of the present invention shall be regarded as an example for understanding the present invention but not belonging to the present invention.

To sum up, there provided are a semiconductor structure and a method of manufacturing the same. By disposing between the first conductive layer and the second conductive layer the dielectric layer as a barrier layer so as to prevent the conductive materials in the first conductive layer from diffusing into the second conductive layer, and connecting the first conductive layer to the second conductive layer so as to form an equipotential, the performance of the device is improved.

### BRIEF DESCRIPTION OF THE DRAWINGS

FIG. 1 is a flowchart of a method of manufacturing a semiconductor structure according to an embodiment; and
FIGS. 2-10 are schematic structural diagrams of the structures of the semiconductor structure produced through individual steps according to an embodiment.

### DETAILED DESCRIPTION OF THE EMBODIMENTS

The detailed description of the present disclosure is given below in combination with drawings for the purpose of making the above objectives, features, and advantages of the present disclosure more obvious and understandable. Many specific details are elaborated in the description below so as to fully comprehend the present disclosure. However, the present disclosure may be implemented in a number of other ways which are different from those described herein. The person skilled in the art can make similar improvements without departing from the connotation of the present disclosure. Therefore, the present disclosure is not limited to the specific implementations disclosed below.

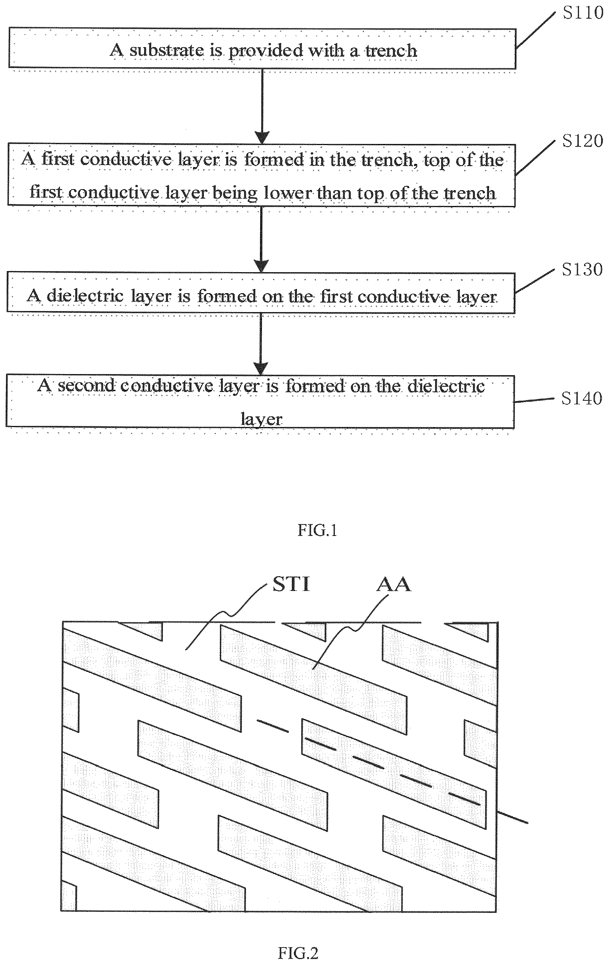

Referring to Figs. 1-10, a method of manufacturing a semiconductor structure according to an embodiment is provided. The method includes the following steps:
Step S110: providing a substrate 100 with a trench 103;
Step S120: forming a first conductive layer 200 in the trench 103, wherein the top of the first conductive layer 200 is lower than the top of the trench 103;
Step S130: forming a dielectric layer 300 on the first conductive layer 200; and
Step S140: forming a second conductive layer 400 on the dielectric layer 300.

The performances of the first conductive layer 200 and the second conductive layer 400 are ensured by disposing between the first conductive layer 200 and the second conductive layer 400 the dielectric layer 300 as a barrier layer so as to prevent the conductive materials in the first conductive layer 200 from diffusing into the second conductive layer 400.

For convenience of description, the sequential order of the processing steps is followed below to, referring to Figs. 2-10, describe the method of manufacturing the provided semiconductor device in detail.

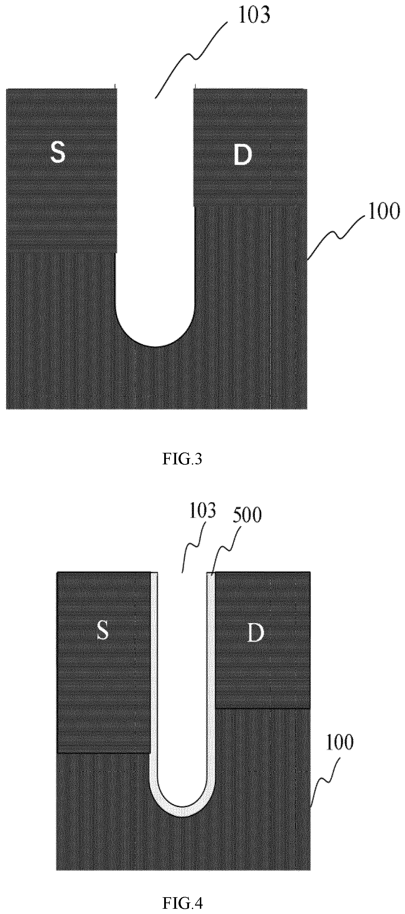

Referring to Figs. 2 and 3, the step S110 of providing a substrate 100 with a trench 103 is performed and may include the following steps.

Step 1: a substrate 100 is provided. In general, the substrate 100 may be, but not limited to, a silicon substrate, an epitaxial silicon substrate, a silicon-germanium substrate, a silicon-coated insulating substrate, or any substrate for bearing the components of the semiconductor integrated circuit, as well known by the person skilled in the art.

A shallow trench isolation (STI) structure and active areas AAs are formed on the substrate 100, wherein the shallow trench isolation structure isolates the active areas from the ambient environment. The active area may be either a fin-like three-dimensional structure or a planar structure. In the case where the semiconductor device to be manufactured is a memory, the shallow trench isolation structure may isolate the active areas into an array arrangement, thereby manufacturing the storage array of the memory. The shallow trench isolation structure may include shallow trenches located in the substrate 100 and isolation materials filling the shallow trenches. The isolation materials may include line oxide formed and covering the shallow trench by the thermal oxidation process and silicon oxide located on the surface of the line oxide layer and filling up the shallow trench, thereby improving the isolation performance of the shallow trench isolation structure.

Step 2: referring to Fig. 3, a trench 103 is formed on the substrate 100.

In some embodiments, the trench 103 is formed on the active area AA of the substrate 100. In general, the forming process includes the following steps. (1) A hard mask layer is formed. In some embodiments, the hard mask layer may be formed by utilizing the deposition process to deposit insulating material on the surface having the shallow trench isolation structure and a pad oxide layer. The deposition process includes chemical vapor deposition (CVD), physical vapor deposition (PVD), atomic layer deposition (ALD), or the like. The insulating materials usually adopted include at least one of silicon nitride, silicon oxynitride, silicon carbonoxide, metal nitride, metal oxide and metal carbide, preferably silicon nitride (SiN), because the SiN material is easily available and has advantages of low cost, mature manufacturing approaches, etc., and also has a high etch selectivity ratio with silicon oxide in the pad oxide layer. (2) The hard mask layer is patterned to form an opening pattern passing through the hard mask layer. In some embodiments, a matched mask can be utilized to form a pattern for defining the trench by a series of photolithographic processes, such as coating photoresist, exposure, and develop. Then, with the photoresist layer having the pattern serving as a mask, the hard mask layer is etched to the surface of the pad oxide layer, so as to form a patterned hard mask layer having the opening pattern. (3) The photoresist is removed, and the patterned hard mask layer serves as a mask to etch down further, so as to form the trench 103 in the active area AA of the substrate 100.

In an example, as shown in Fig. 2, a plurality of active areas AAs are distributed in an array, and a single active area AA is strip-like. The number of trenches formed on a single active area AA is unlimited. For example, two trenches are formed in a single active area AA. In some embodiments, the active areas AAs are an array of active areas for DRAM storage, and the word line trenches for burying the gates are formed on the active areas AAs. The word line trenches are equally spaced and in parallel arrangement, and a single active area AA is provided with two word line trenches.

In an example, the active area AA is doped to form a source S on one side of the trench 103 and/or a drain D on the other side of the trench 103 respectively. In some embodiments, in the case where two trenches are formed in a single active area AA, a common source S is formed between the two trenches, and drains D correspond to the outer sides of the two trenches. In other examples, the time of forming the source S and the drain D during the process flow may be adjusted according to the practical situation of the process, which is not limited herein. For example, the source S and the drain D may also be formed after the trench 103 is formed, or may further be formed after the second conductive layer is formed.

Step 3: the pad oxide layer, the hard mask layer, etc. on the surface of the substrate 100 are removed by the etch process, the chemical-mechanical planarization process, or the like, and cleaning is further conducted to expose the clean surfaces of the active areas and the side walls and bottom surface of the trench 103.

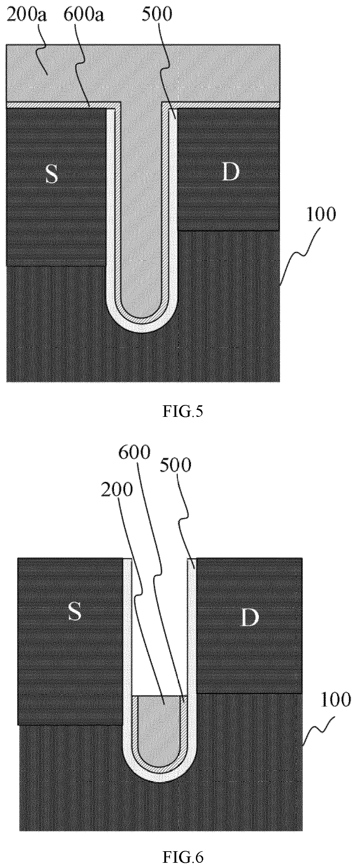

Referring to Figs. 5 and 6, the step S120 of forming a first conductive layer 200 in the trench 103 is performed, wherein the top of the first conductive layer 200 is lower than the top of the trench 103.

In one of the embodiments, as shown in the Fig. 4, prior to forming the first conductive layer in the trench 103, the method further includes:
forming a first dielectric layer on the surface of the trench, wherein the first dielectric layer extends to the top of the trench. In some embodiments, a first dielectric layer 500 is formed on the side walls and bottom of the trench 103, wherein the first dielectric layer 500 covers the side walls and bottom of the trench 103 and extends to the top of the trench 103. In some embodiments, the first dielectric layer is a gate dielectric layer; the first dielectric layer 500 may be formed by utilizing the deposition process or the thermal oxidation process to form a silicon oxide material layer on the substrate 100 and the side walls and bottom of the trench 103, and then utilizing the etch process or the chemical-mechanical grinding process to remove the silicon oxide material on the surface of the substrate 100, while retaining the silicon oxide material layer on the side walls and bottom of the trench 103. In addition, dielectric materials of high K (the dielectric constant is greater than 7) may also be used to replace the silicon oxide material. commonly used dielectric materials of high K include Ta₂O₅, TiO₂, TiN, Al₂O₃, Pr₂O₃, La₂O₃, LaAlO₃, HfO₂, ZrO₂, or metal oxide of other constituents.

In one of the embodiments, the step of forming a first conductive layer 200 in the trench 103 further includes: forming a barrier material layer 600a, wherein the barrier material layer 600a covers the substrate 100 and the surface of the first dielectric layer 500 on the side walls and bottom of the trench 103; forming a first conductive material layer 200a for filling the trench 103, wherein the first conductive material layer 200a covers the barrier material layer 600a; etching back the barrier material layer 600a and the first conductive material layer 200a so as to form a barrier layer 600 and the first conductive layer 200, wherein the barrier layer 600 is located between the first conductive layer 200 and the first dielectric layer 500 and extends to the top of the first conductive layer 200. Both of the top of the first conductive layer 200 and the top of the barrier layer 600 are lower than the top of the trench 103. The step may include the following steps.
1. A deposition process, such as ALD, CVD, or PVD, is utilized to deposit the barrier material, so as to form a barrier material layer 600a covering the substrate 100 and the side walls and bottom of the trench 103. In this embodiment, the barrier material layer 600a can prevent the conductive material in the first conductive layer 200 from diffusing into the first dielectric layer 500 and thus, affecting the performance of the first dielectric layer 500. Besides, the barrier material layer 600a has the function of strengthening the adhesive force between the first conductive layer 200 and the first dielectric layer 500. Additionally, in order to ensure the barrier material layer 600a to provide sufficient protection to the first dielectric layer 500, the formed barrier material layer 600a may have a multilayer stacked composite structure.
2. A deposition process, such as CVD or PVD, is utilized to form a first conductive material layer 200a, which fills up the trench 103 and covers the barrier material layer 600a. In some embodiments, the first conductive material layer 200a is a metal material layer, wherein the metal materials include tungsten, cobalt, manganese, niobium, nickel, molybdenum, and other metal materials having good conductivity.
3. The barrier material layer 600a and the first conductive material layer 200a are etched back to form a barrier layer 600 and the first conductive layer 200, and ensure that the height of the barrier layer 600 is not lower than that of the first conductive layer 200 (see Fig. 6). In some embodiments, the barrier material layer 600a and the first conductive material layer 200a on the surface of the substrate 100 and the upper portion of the side walls of the trench 103 are removed to form a first conductive layer 200 merely located at the lower portion of the trench 103.

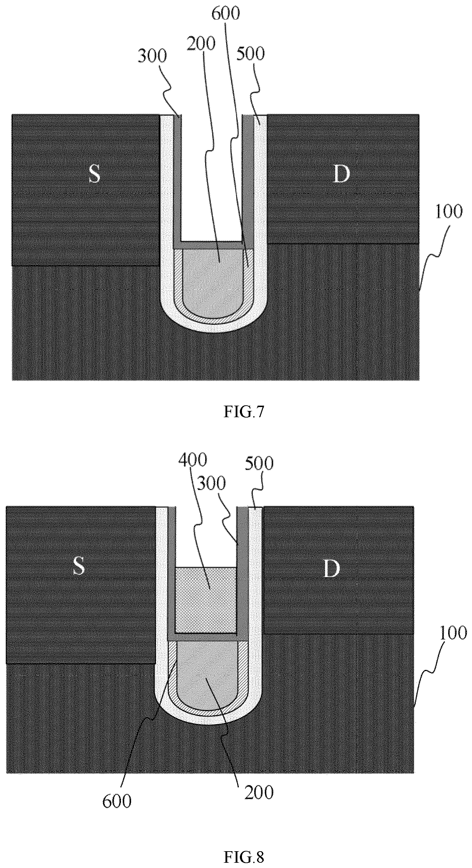

Referring to Fig. 7, the step S130 of forming a dielectric layer 300 on the first conductive layer 200 is performed.

In one of the embodiments, the step of forming a dielectric layer 300 on the first conductive layer 200 includes: forming a dielectric material layer by a deposition process, such as ALD, PECVD, LPCVD, or MOCVD, wherein the dielectric material layer covers the upper surface of the first conductive layer 200, the upper surface of the substrate 100, and the side walls of the trench 103. The dielectric material layer located on the upper surface of the substrate 100 is removed to form the dielectric layer 300 at least covering the upper surface of the first conductive layer 200. In this embodiment, disposing the dielectric layer 300 between the first conductive layer 200 and the second conductive layer 400 may effectively prevent the conductive material in the first conductive layer 200 from diffusing into the second conductive layer 400.

In other examples, the dielectric layer 300 also covers the side walls of the trench 103 above the first conductive layer 200. The step may include: forming a dielectric material layer on the upper surface of the substrate 100, the upper surface of the first conductive layer 200, and the side walls of the trench 103 by ALD, PECVD, LPCVD, MOCVD, or other deposition processes; then, removing the dielectric material layer covering the upper surface of the substrate 100, so as to form the dielectric layer 300. The dielectric layer 300 on the side walls of the trench 103 can block the conductive material of the second conductive layer from diffusing into the first dielectric layer 500. In other embodiments, as shown in Fig. 8, the dielectric material layer may also be covered by a second conductive material layer which fills up the trench. The second conductive material layer and the dielectric layer located on the upper surface of the substrate are etched back to form a dielectric layer 300 and a second conductive layer 400.

The dielectric layer 300 is an equipotential dielectric layer causing the potential of the first conductive layer 200 equal to the potential of the second conductive layer 400. The equipotential dielectric layer has a blocking effect while having a thin thickness, thereby enabling electrons to pass through, by the tunneling effect, the potential barrier formed by the equipotential dielectric layer and thus, connect the first conductive layer 200 to the second conductive layer 400 so as to form an equipotential. The equipotential dielectric layer has a thickness less than 20nm. It can be appreciated that if the equipotential dielectric layer is too thin, it may not effectively block the conductive materials in the first conductive layer 200 from diffusing into the second conductive layer 400, and if the equipotential dielectric layer is too thick, it may form an excessively large potential barrier, such that the electrons in the first conductive layer 200 and the second conductive layer 400 cannot pass through the equipotential dielectric layer by the tunneling effect, affecting the performance of the semiconductor device. The thickness range of the equipotential dielectric layer is controlled to be 0-20nm, which can effectively block the conductive materials in the first conductive layer 200 from diffusing into the second conductive layer 400, and can also ensure that the electrons are capable of passing through, by the tunneling effect, the potential barrier formed by the equipotential dielectric layer, so that the first conductive layer 200 and the second conductive layer 400 are equipotential. In some embodiments, the equipotential dielectric layer has a thickness range of 1nm-8nm. The equipotential dielectric layer includes any one or combination of silicon oxide, silicon nitride, silicon oxynitride, silicon carbonoxide, and silicon carbonitride. These materials can be well compatible with the existing semiconductor technology, and also have relatively low barrier potentials, which facilitate the electrons to cause, by the tunneling effect, the first conductive layer 200 and the second conductive layer 400 to be equipotential.

In an example, a source and a drain are formed on the substrate, wherein the source is located on one side of the trench and the drain is located on the other side of the trench respectively, the bottom of the source is lower than the bottom of the drain, and the bottom of the drain is at the same height as the equipotential dielectric layer. The bottom of the source may be interpreted as the bottom of the source doped with an ion distribution area, and the bottom of the drain may be interpreted as the bottom of the drain doped with an ion distribution area. In some embodiments, as shown in Fig. 7, a source S is formed on one side of the trench and a drain D is formed on the other side of the trench respectively, wherein the bottom of the source S is lower than the bottom of the drain D, and the bottom of the drain D is at the same height as the equipotential dielectric layer. In some embodiments, the bottom of the drain D is at the same level as the equipotential dielectric layer. Such an arrangement can not only reduce the length of the channel and increase the speed of the device, but also well suppress the gate-induced drain leakage current at the drain region.

In other examples, the bottom of the drain D is above the height at which the equipotential dielectric layer is located, but lower than the height of the top of the second conductive layer formed subsequently.

Referring to Fig.8, the step S140 of forming a second conductive layer 400 on the dielectric layer 300 is performed. The forming process may include: depositing a second conductive material layer by a deposition process, wherein the second conductive material layer fills up the trench 103 and covers the surface of the substrate 100; then, the second conductive material layer located on the surface of the substrate 100 is removed by an etch back process, or a chemical-mechanical grinding process in combination with an etch back process, so as to form a second conductive layer 400. In this embodiment, the second conductive layer 400 is a semiconductor conductive layer. The materials of the semiconductor conductive layer include any one or combination of polycrystalline silicon, silicon germanide, gallium arsenide, gallium phosphide, cadmium sulphide, and zinc sulphide. The composite power function gate formed by the semiconductor conductive layer in combination with the first conductive layer can properly address the problem of the gate-induced drain leakage current.

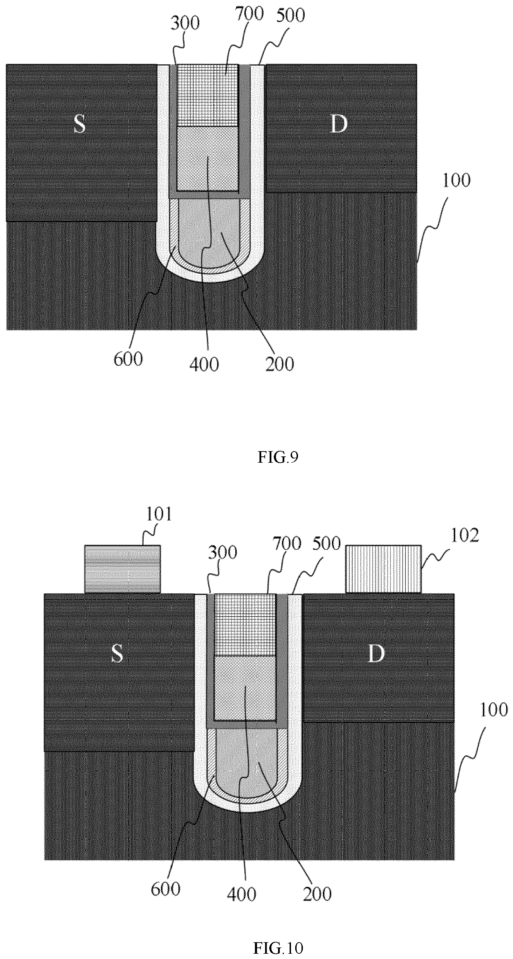

Referring to Fig. 9, in one of the embodiments, the method of manufacturing the semiconductor structure further includes:

forming an insulation layer 700 for filling the trench 103, wherein the insulation layer 700 is located on the second conductive layer 400 and flush with the upper surface of the substrate 100. In some embodiments, the top of the formed second conductive layer 400 is lower than the top of the trench, so as to increase the distance from the second conductive layer 400 to a storage node plug and a bit line connecting plug formed subsequently, reducing the parasitic capacitance. A good protection and insulation effect can be achieved by filling up the trench 103 with dielectric materials of low K, such as silicon nitride, which has an increased bandwidth and a good insulating property. In addition, the insulation layer 700 is flush with the upper surface of the substrate 100 so as to form a flat surface, which is beneficial of forming other structures thereon.

Referring to Fig. 10, the method of manufacturing the semiconductor structure further includes forming a bit line connecting plug 101 and a storage node plug 102, wherein the bit line connecting plug 101 is electrically connected to the source S, and the storage node plug 102 is electrically connected to the drain D. In addition, the bit line connecting plug 101 is also connected to a bit line, and the storage node plug 102 is also connected to a storage cell, such as a capacitive storage cell, a resistive storage cell, a phase change storage cell, a magnetic storage cell, or the like. In this embodiment, the bit line connecting plug 101 and a bit line (not shown in the drawing) are first formed on the source S region, and then, the storage node plug 102 is formed on the drain D region. In some other embodiments, it may be possible to dispose the storage node plug 102 on the source S region, and dispose the bit line connecting plug 101 on the drain D region. In some embodiments, the bit line connecting plug 101 and the bit line may be formed by patterning a multilayer stacked structure. The detailed process is not repeated herein. For example, a multilayer stacked structure, which has a non-metal conductive layer, a metal layer and a bit line insulation layer stacked in order, may be formed on the substrate 100, and then patterned to form the bit line connecting plug 101 and the bit line. After the bit line connecting plug 101 and the bit line are formed, a storage node contact hole is formed by a multi-times patterning process, and then filled with conductive materials, so as to form the storage node plug 102. In some embodiments, the bottom of the source S is lower than the bottom of the drain D, and the bottom of the drain D is at the same height as the equipotential dielectric layer. In some embodiments, the bottom of the drain D is at the same level as the equipotential dielectric layer. Such an arrangement can not only reduce the length of the channel and increase the speed of the device, but also well restrain the storage cell electrically connected to the drain D by the storage node plug 102 from losing or missing of the stored signal due to the effect of gate-induced drain leakage current.

Referring to Fig. 10 continuously, a semiconductor structure is also provided based on the same inventive concept. The semiconductor structure includes a substrate 100, a first conductive layer 200, a dielectric layer 300, and a second conductive layer 400. The substrate 100 has a trench 103 therein. The first conductive layer 200 is located in the trench 103, and the top of the first conductive layer 200 is lower than the top of the trench 103. The dielectric layer 300 is located on the first conductive layer 200. The second conductive layer 400 is located on the dielectric layer 300.

In this embodiment, the substrate 100 may be, but not limited to, a silicon substrate, an epitaxial silicon substrate, a silicon-germanium substrate, a silicon-coated insulating substrate, or any substrate for bearing the components of the semiconductor integrated circuit, as well known by the person skilled in the art. In some embodiments, active areas AAs distributed in an array are formed on the substrate 100, and the trench 103 is formed in the active area AA. The active areas AAs distributed in an array may be the active areas of a storage element, which may be DRAM, SRAM, PCRAM, RRAM, or the like.

In one of the embodiments, the semiconductor structure further includes a first dielectric layer 500 located on the surface of the trench and extending to the top of the trench. In some embodiments, the first dielectric layer 500 is located on the side walls and bottom of the trench 103 and between the first conductive layer 200 and the substrate 100. In some embodiments, the first dielectric layer 500 may be formed by utilizing a deposition process or a thermal oxidation process to form a silicon oxide material layer on the substrate 100 and the side walls and bottom of the trench 103, and then utilizing an etch process to remove the silicon oxide material on the semiconductor surface. In some embodiments, the first dielectric layer 500 is a gate dielectric layer. In addition, dielectric materials of high K may also be used to replace the silicon oxide material. Commonly used dielectric materials of high K include Ta₂O₅, TiO₂, TiN, Al₂O₃, Pr₂O₃, La₂O₃, LaAlO₃, HfO₂, ZrO₂, or metal oxide of other constituents.

In one of the embodiments, the semiconductor structure further includes a barrier layer 600. The barrier layer 600 is located between the first dielectric layer 500 and the first conductive layer 200. In this embodiment, the barrier layer 600 is manufactured by using a deposition process, such as ALD, PVD, or CVD, so as to prevent the metal in the first conductive layer 200 from diffusing into the first dielectric layer 500 and thus, affecting the performance of the first dielectric layer 500. Besides, the barrier layer 600 has the function of strengthening the adhesive force between the first conductive layer 200 and the first dielectric layer 500. Additionally, in order to ensure the barrier layer 600 to provide sufficient protection to the first dielectric layer 500, the formed barrier layer 600 has a multilayer stacked composite structure under normal conditions.

In one of the embodiments, the first conductive layer is a metal conductive layer, and the materials of the metal conductive layer include any one or combination of tungsten, cobalt, manganese, niobium, nickel, and molybdenum. The first conductive layer 200 may be formed by utilizing evaporation, electroplating, magnetron sputtering or other processes to form a first conductive material layer, and then etching back the first conductive material layer.

The dielectric layer 300 is an equipotential dielectric layer causing the potential of the first conductive layer 200 equal to the potential of the second conductive layer 400. The equipotential dielectric layer covering the upper surface of the first conductive layer 200 may effectively prevent the conductive material in the first conductive layer 200 from diffusing into the second conductive layer 400. The equipotential dielectric layer has a blocking effect while having a small thickness, thereby enabling electrons to pass through, by the tunneling effect, the potential barrier formed by the equipotential dielectric layer and thus, connect the first conductive layer 200 to the second conductive layer 400 so as to form an equipotential. The equipotential dielectric layer has a thickness less than 20nm. It can be appreciated that if the equipotential dielectric layer is too thin, it may not effectively block the conductive materials in the first conductive layer 200 from diffusing into the second conductive layer 400, and if the equipotential dielectric layer is too thick, it may form an excessively large potential barrier, such that the electrons in the first conductive layer 200 and the second conductive layer 400 cannot pass through the equipotential dielectric layer by the tunneling effect, affecting the performance of the semiconductor device. The thickness range of the equipotential dielectric layer is controlled to be 0-20nm, which can effectively block the conductive materials in the first conductive layer 200 from diffusing into the second conductive layer 400, and can also ensure that the electrons are capable of passing through, by the tunneling effect, the potential barrier formed by the equipotential dielectric layer, so that the first conductive layer 200 and the second conductive layer 400 are equipotential. In some embodiments, the equipotential dielectric layer has a thickness range of 1nm-8nm. The equipotential dielectric layer includes any one or combination of silicon oxide, silicon nitride, silicon oxynitride, silicon carbonoxide, and silicon carbonitride. These materials can be well compatible with the existing semiconductor technology, and also have relatively low barrier potentials, which facilitate the electrons to cause, by the tunneling effect, the first conductive layer 200 and the second conductive layer 400 to be equipotential.

In one of the embodiments, the second conductive layer is a semiconductor conductive layer. The materials of the semiconductor conductive layer include any one or combination of polycrystalline silicon, silicon germanide, gallium arsenide, gallium phosphide, cadmium sulphide, and zinc sulphide. For example, the second conductive layer 400 may use doped polycrystalline silicon. In this embodiment, the forming process of the second conductive layer 400 may include: depositing polycrystalline silicon material by a deposition process to form a polycrystalline silicon material layer, wherein the polycrystalline silicon material layer fills up the trench 103 and covers the surface of the substrate 100; and then, removing the polycrystalline silicon material layer on the surface of the substrate 100 by an etch back process to form the second conductive layer 400, wherein the top of the second conductive layer 400 is lower than the top of the trench. The composite power function gate formed by the semiconductor conductive layer in combination with the first conductive layer can properly address the problem of the gate-induced drain leakage current.

In one of the embodiments, the semiconductor structure further includes a source S located on one side of the trench and a drain D located on the other side of the trench 103 respectively, wherein the bottom of the source is lower than the bottom of the drain, and the bottom of the drain is at the same height as the equipotential dielectric layer. Such an arrangement can not only reduce the length of the channel and increase the speed of the device, but also well suppress the gate-induced drain leakage current at the drain region.

In one of the embodiments, the semiconductor structure further includes an insulation layer 700.

The insulation layer 700 is located on the surface of the second conductive layer 400, and fills the trench 103 up to be flush with the upper surface of the substrate 100. In some embodiments, the top of the formed second conductive layer 400 is lower than the bottom of the trench, so as to increase the distance from the second conductive layer 400 to a storage node plug and a bit line connecting plug formed subsequently, reducing the parasitic capacitance. A good protection and insulation effect can be achieved by filling up the trench 103 with dielectric materials of low K, such as silicon nitride, which has an increased bandwidth and a good insulating property. In addition, the insulation layer 700 is flush with the upper surface of the substrate 100 so as to form a flat surface, which is beneficial of forming other structures thereon.

In one embodiment, the semiconductor structure further includes a bit line connecting plug 101 located on the source S and a storage node plug 102 located on the drain D. The bit line connecting plug 101 is electrically connected to the source S, and the storage node plug 102 is electrically connected to the drain D. The bottom of the source S is lower than the bottom of the drain D, and the bottom of the drain D is at the same level as the equipotential dielectric layer located on the surface of the second conductive layer 400. Such an arrangement can not only reduce the length of the channel and increase the speed of the device, but also well restrain the storage cell electrically connected to the drain D by the storage node plug 102 from losing or missing of the stored signal due to the effect of gate-induced drain leakage current.

Technical features of the embodiments described above may be arbitrarily combined, but not all of the potential combinations are described so as to make the description concise. However, all of the combinations of these technical features should be considered as the scope recited in the specification as long as they have no conflict therein.

The embodiments described above merely show several implementations of the present disclosure. The descriptions thereof are specific and detailed, but should not be interpreted as limiting the scope of the disclosure patent. It should be noted that the person skilled in the art could further make several variations and improvements without departing the present inventive concept, and these variations and improvements belong to the scope sought for protection in the present disclosure. Therefore, the scope sought for protection in the present disclosure patent should take the accompanying claims as the criterion.

## Claims

1. A method of manufacturing a semiconductor structure, comprising:
providing (S1 10) a substrate (100) with a trench (103);
forming (S120) a first conductive layer (200) in the trench, top of the first conductive layer being lower than top of the trench;
forming (S130) a dielectric layer (300) on the first conductive layer; and
forming (S140) a second conductive layer (400) on the dielectric layer;
**characterized in that**, the dielectric layer is an equipotential dielectric layer, the equipotential dielectric layer is configured to cause potential of the first conductive layer equal to potential of the second conductive layer; and
the equipotential dielectric layer has a thickness less than 20nm;
wherein the equipotential dielectric layer has a blocking effect, preventing the conductive materials in the first conductive layer (200) from diffusing into the second conductive layer (400), while having a thin thickness, such that electrons are enabled to pass through, by a tunneling effect, a potential barrier formed by the equipotential dielectric layer and thus, the first conductive layer (200) and the second conductive layer (400) are connected to form an equipotential.

2. The method according to claim 1, further comprising:
forming a first dielectric layer (500) on surface of the trench, wherein the first dielectric layer extends to the top of the trench.

3. The method according to claim 1, further comprising:
forming a source (S) on one side of the trench and a drain (D) on the other side of the trench respectively, the bottom of the source being lower than the bottom of the drain, and the bottom of the drain being at same height as the equipotential dielectric layer.

4. The method according to claim 3, further comprising:
forming a bit line connecting plug (101) on the source; and
forming a storage node plug (102) on the drain.

5. The method according to claim 2, further comprising:
forming a barrier layer (600) on a surface of the first dielectric layer, wherein the barrier layer is located between the first conductive layer and the first dielectric layer, and extends to the top of the first conductive layer.

6. The method according to claim 1, wherein forming a dielectric layer on the first conductive layer comprises:
forming an equipotential dielectric material layer by a deposition process, the equipotential dielectric material layer covering upper surface of the first conductive layer, upper surface of the substrate, and side walls of the trench; and
removing the equipotential dielectric material layer located on the upper surface of the substrate, so as to form the equipotential dielectric layer covering the upper surface of the first conductive layer and the side walls of the trench above the first conductive layer.

7. A semiconductor structure, comprising:
a substrate (100) with a trench (103);
a first conductive layer (200) located in the trench (103), top of the first conductive layer (200) being lower than top of the trench (103);
a dielectric layer (300) located on the first conductive layer (200); and
a second conductive layer (400) located on the dielectric layer (300);
**characterized in that**, the dielectric layer (300) is an equipotential dielectric layer causing potential of the first conductive layer (200) equal to potential of the second conductive layer (400); and
the equipotential dielectric layer has a thickness less than 20nm, preferably has a thickness range of 1-8nm;
wherein the equipotential dielectric layer has a blocking effect, preventing the conductive materials in the first conductive layer (200) from diffusing into the second conductive layer (400), while having a thin thickness, such that electrons are enabled to pass through, by a tunneling effect, a potential barrier formed by the equipotential dielectric layer and thus, the first conductive layer (200) and the second conductive layer (400) are connected to form an equipotential.

8. The semiconductor structure according to claim 7,
wherein insulating material of the equipotential dielectric layer is selected from one of silicon oxide, silicon nitride, silicon oxynitride, silicon carbonoxide, and silicon carbonitride, or their combination.

9. The semiconductor structure according to claim 7, wherein the first conductive layer (200) is a metal conductive layer, and the second conductive layer (400) is a semiconductor conductive layer, and
wherein material of the metal conductive layer is selected from one of tungsten, cobalt, manganese, niobium, nickel, and molybdenum, or their combination; and material of the semiconductor conductive layer is selected from one of polycrystalline silicon, silicon germanide, gallium arsenide, gallium phosphide, cadmium sulphide, and zinc sulphide, or their combination.

10. The semiconductor structure according to claim 7, further comprising:
a source (S) located on one side of the trench (103) and a drain (D) located on the other side of the trench (103) respectively, bottom of the source (S) being lower than bottom of the drain (D), and the bottom of the drain (D) being at same height as the equipotential dielectric layer;
a bit line connecting plug (101) located on the source (S); and
a storage node plug (102) located on the drain (D).

11. The semiconductor structure according to claim 7, further comprising:
a first dielectric layer (500) located on a surface of the trench (103) and extending to the top of the trench (103); and
a barrier layer (600) located between the first conductive layer (200) and the first dielectric layer (500), and extending to the top of the first conductive layer (200),
wherein the dielectric layer (300) is also located on side walls of the trench (103) above the first conductive layer (200).

## Patentansprüche

1. Verfahren zur Herstellung einer Halbleiterstruktur, umfassend:
Bereitstellen (S110) eines Substrats (100) mit einem Graben (103);
Bilden (S120) einer ersten leitenden Schicht (200) in dem Graben, wobei die Oberseite der ersten leitenden Schicht niedriger als die Oberseite des Grabens ist;
Bilden (S130) einer dielektrischen Schicht (300) auf der ersten leitenden Schicht; und
Bilden (S140) einer zweiten leitenden Schicht (400) auf der dielektrischen Schicht;
**dadurch gekennzeichnet, dass** die dielektrische Schicht eine äquipotentiale dielektrische Schicht ist, wobei die äquipotentiale dielektrische Schicht so konfiguriert ist, dass das Potential der ersten leitenden Schicht gleich dem Potential der zweiten leitenden Schicht ist; und
die äquipotentiale dielektrische Schicht eine Dicke von weniger als 20 nm aufweist;
wobei die äquipotentiale dielektrische Schicht eine Sperrwirkung aufweist, die die leitenden Materialien in der ersten leitenden Schicht (200) daran hindert, in die zweite leitende Schicht (400) zu diffundieren, während sie eine dünne Dicke aufweist, wodurch Elektronen in die Lage versetzt werden, durch einen Tunneleffekt eine durch die äquipotentiale dielektrische Schicht gebildete Potentialbarriere zu durchdringen, und somit die erste leitende Schicht (200) und die zweite leitende Schicht (400) verbunden sind, um ein Äquipotential zu bilden.

2. Verfahren nach Anspruch 1, weiter umfassend:
Bilden einer ersten dielektrischen Schicht (500) auf der Oberfläche des Grabens, wobei sich die erste dielektrische Schicht bis zur Oberseite des Grabens erstreckt.

3. Verfahren nach Anspruch 1, weiter umfassend:
Bilden einer Source (S) auf einer Seite des Grabensund, entsprechend, eines Drains (D) auf der anderen Seite des Grabens, wobei der Boden der Source niedriger als der Boden des Drains ist und der Boden des Drains auf derselben Höhe wie die äquipotentiale dielektrische Schicht ist.

4. Verfahren nach Anspruch 3, weiter umfassend:
Bilden eines Bitleitungsanschlusssteckers (101) an der Source; und
Bilden eines Speicherknotensteckers (102) an dem Drain.

5. Verfahren nach Anspruch 2, weiter umfassend:
Bilden einer Sperrschicht (600) auf einer Oberfläche der ersten dielektrischen Schicht, wobei sich die Sperrschicht zwischen der ersten leitenden Schicht und der ersten dielektrischen Schicht befindet und sich bis zur Oberseite der ersten leitenden Schicht erstreckt.

6. Verfahren nach Anspruch 1, wobei das Bilden einer dielektrischen Schicht auf der ersten leitenden Schicht Folgendes umfasst:
Bilden einer äquipotentialen dielektrischen Materialschicht durch einen Abscheidungsprozess, wobei die äquipotentiale dielektrische Materialschicht die Oberseite der ersten leitenden Schicht, die Oberseite des Substrats und die Seitenwände des Grabens bedeckt; und
Entfernen der äquipotentialen dielektrischen Materialschicht, die sich auf der Oberseite des Substrats befindet, um die äquipotentiale dielektrische Schicht zu bilden, die die Oberseite der ersten leitenden Schicht und die Seitenwände des Grabens oberhalb der ersten leitenden Schicht bedeckt.

7. Halbleiterstruktur, umfassend:
ein Substrat (100) mit einem Graben (103);
eine erste leitende Schicht (200), die sich in dem Graben (103) befindet, wobei die Oberseite der ersten leitenden Schicht (200) niedriger ist als die Oberseite des Grabens (103);
eine dielektrische Schicht (300), die sich auf der ersten leitenden Schicht (200) befindet; und
eine zweite leitende Schicht (400), die sich auf der dielektrischen Schicht (300) befindet;
**dadurch gekennzeichnet, dass** die dielektrische Schicht (300) eine äquipotentiale dielektrische Schicht ist, die bewirkt, dass das Potential der ersten leitenden Schicht (200) gleich dem Potential der zweiten leitenden Schicht (400) ist; und
die äquipotentiale dielektrische Schicht eine Dicke von weniger als 20 nm, vorzugsweise einen Dickenbereich von 1 bis 8 nm, aufweist;
wobei die äquipotentiale dielektrische Schicht eine Sperrwirkung aufweist, die die leitenden Materialien in der ersten leitenden Schicht (200) daran hindert, in die zweite leitende Schicht (400) zu diffundieren, während sie eine dünne Dicke aufweist, wodurch Elektronen in die Lage versetzt werden, durch einen Tunneleffekt eine durch die äquipotentiale dielektrische Schicht gebildete Potentialbarriere zu durchdringen, und somit die erste leitende Schicht (200) und die zweite leitende Schicht (400) verbunden sind, um ein Äquipotential zu bilden.

8. Halbleiterstruktur nach Anspruch 7,
wobei das Isoliermaterial der äquipotentialen dielektrischen Schicht aus einem von Siliziumoxid, Siliziumnitrid, Siliziumoxynitrid, Siliziumkarbonoxid und Siliziumkarbonitrid oder einer Kombination davon ausgewählt ist.

9. Halbleiterstruktur nach Anspruch 7, wobei die erste leitende Schicht (200) eine metallische leitende Schicht ist und die zweite leitende Schicht (400) eine halbleitende leitende Schicht ist, und
wobei das Material der metallischen leitenden Schicht ausgewählt ist aus Wolfram, Kobalt, Mangan, Niob, Nickel und Molybdän oder einer Kombination davon; und das Material der halbleitenden Schicht ausgewählt ist aus polykristallinem Silizium, Siliziumgermanid, Galliumarsenid, Galliumphosphid, Cadmiumsulfid und Zinksulfid oder einer Kombination davon.

10. Halbleiterstruktur nach Anspruch 7, weiter umfassend:
eine Source (S), die sich auf einer Seite des Grabens (103) befindet, und einen Drain (D), der sich auf der anderen Seite des Grabens (103) befindet, wobei der Boden der Source (S) niedriger als der Boden des Drains (D) ist und der Boden des Drains (D) auf derselben Höhe wie die äquipotentiale dielektrische Schicht liegt;
einen Bitleitungsanschlussstecker (101), der sich auf der Source (S) befindet; und
einen Speicherknotenstecker (102), der sich auf dem Drain (D) befindet.

11. Halbleiterstruktur nach Anspruch 7, weiter umfassend:
eine erste dielektrische Schicht (500), die sich auf einer Oberfläche des Grabens (103) befindet und sich bis zur Oberseite des Grabens (103) erstreckt; und
eine Sperrschicht (600), die sich zwischen der ersten leitenden Schicht (200) und der ersten dielektrischen Schicht (500) befindet und sich bis zur Oberseite der ersten leitenden Schicht (200) erstreckt,
wobei sich die dielektrische Schicht (300) auch auf Seitenwänden des Grabens (103) oberhalb der ersten leitenden Schicht (200) befindet.

## Revendications

1. Procédé de fabrication d'une structure semi-conductrice, comprenant les étapes consistant à :
munir (5110) un substrat (100) d'une tranchée (103) ;
former (S120) une première couche conductrice (200) dans la tranchée, le sommet de la première couche conductrice étant plus bas que le sommet de la tranchée ;
former (S130) une couche diélectrique (300) sur la première couche conductrice ; et
former (S140) une deuxième couche conductrice (400) sur la couche diélectrique :
**caractérisé en ce que** la couche diélectrique est une couche diélectrique équipotentielle, la couche diélectrique équipotentielle est configurée pour amener un potentiel de la première couche conductrice égal au potentiel de la deuxième couche conductrice ; et
la couche diélectrique équipotentielle a une épaisseur inférieure à 20 nm ;
dans lequel la couche diélectrique équipotentielle a un effet de blocage empêchant les matériaux conducteurs de la première couche conductrice (200) de se diffuser dans la deuxième couche conductrice (400), tout en ayant une fine épaisseur, de telle sorte que les électrons peuvent passer à travers, par un effet tunnel, une barrière de potentiel formée par la couche diélectrique équipotentielle et ainsi, la première couche conductrice (200) et la deuxième couche conductrice (400) sont connectées pour former une équipotentielle.

2. Procédé selon la revendication 1, comprenant en outre l'étape consistant à :
former une première couche diélectrique (500) sur la surface de la tranchée, dans laquelle la première couche diélectrique s'étend jusqu'au sommet de la tranchée.

3. Procédé selon la revendication 1, comprenant en outre l'étape consistant à :
former respectivement une source (S) d'un côté de la tranchée et un drain (D) de l'autre côté de la tranchée, le fond de la source étant plus bas que le fond du drain, et le fond du drain étant à la même hauteur que le couche diélectrique équipotentielle.

4. Procédé selon la revendication 3, comprenant en outre les étapes consistant à :
former une fiche de connexion de ligne de bits (101) sur la source ; et
former un bouchon de noeud de stockage (102) sur le drain.

5. Procédé selon la revendication 2, comprenant en outre :
la formation d'une couche barrière (600) sur une surface de la première couche diélectrique, la couche barrière étant située entre la première couche conductrice et la première couche diélectrique, et s'étend jusqu'au sommet de la première couche conductrice.

6. Procédé selon la revendication 1, dans lequel la formation d'une couche diélectrique sur la première couche conductrice comprend les étapes consistant à :
former une couche de matériau diélectrique équipotentiel par un processus de dépôt, la couche de matériau diélectrique équipotentiel recouvrant la surface supérieure de la première couche conductrice, la surface supérieure du substrat et les parois latérales de la tranchée ; et
retirer la couche de matériau diélectrique équipotentiel située sur la surface supérieure du substrat, de manière à former la couche diélectrique équipotentielle recouvrant la surface supérieure de la première couche conductrice et les parois latérales de la tranchée au-dessus de la première couche conductrice.

7. Structure semi-conductrice, comprenant :
un substrat (100) avec une tranchée (103) ;
une première couche conductrice (200) située dans la tranchée (103), le sommet de la première couche conductrice (200) étant plus bas que le sommet de la tranchée (103) ;
une couche diélectrique (300) située sur la première couche conductrice (200) ; et
une deuxième couche conductrice (400) située sur la couche diélectrique (300);
**caractérisé en ce que** la couche diélectrique (300) est une couche diélectrique équipotentielle provoquant un potentiel de la première couche conductrice (200) égal au potentiel de la deuxième couche conductrice (400) ; et
la couche diélectrique équipotentielle a une épaisseur inférieure à 20 nm, et a de préférence une plage d'épaisseur de 1 à 8 nm ;
dans lequel la couche diélectrique équipotentielle a un effet de blocage empêchant les matériaux conducteurs de la première couche conductrice (200) de se diffuser dans la deuxième couche conductrice (400), tout en ayant une fine épaisseur, de telle sorte que les électrons peuvent passer à travers, par un effet tunnel, une barrière de potentiel formée par la couche diélectrique équipotentielle et ainsi, la première couche conductrice (200) et la deuxième couche conductrice (400) sont connectées pour former une équipotentielle.

8. Structure semi-conductrice selon la revendication 7, dans laquelle le matériau isolant de la couche diélectrique équipotentielle est choisi d'un parmi l'oxyde de silicium, le nitrure de silicium, l'oxynitrure de silicium, le carbonoxyde de silicium et le carbonitrure de silicium, ou leur combinaison.

9. Structure semi-conductrice selon la revendication 7, dans laquelle la première couche conductrice (200) est une couche conductrice métallique, et la deuxième couche conductrice (400) est une couche conductrice semi-conductrice, et dans lequel le matériau de la couche conductrice métallique est choisi parmi le tungstène, le cobalt, le manganèse, le niobium, le nickel et le molybdène, ou leur combinaison ; et le matériau de la couche conductrice semi-conductrice est choisi parmi le silicium polycristallin, le germanure de silicium, l'arséniure de gallium, le phosphure de gallium, le sulfure de cadmium et le sulfure de zinc, ou leur combinaison.

10. Structure semiconductrice selon la revendication 7, comprenant en outre :
une source (S) située d'un côté de la tranchée (103) et un drain (D) situé de l'autre côté de la tranchée (103) respectivement, le fond de la source (S) étant plus bas que le bas du drain (D), et le fond du drain (D) étant à la même hauteur que la couche diélectrique équipotentielle ;
une fiche de connexion de ligne de bits (101) située sur la source (S) ; et
un bouchon de noeud de stockage (102) situé sur le drain (D).

11. Structure semi-conductrice selon la revendication 7, comprenant en outre :
une première couche diélectrique (500) située sur une surface de la tranchée (103) et s'étendant jusqu'au sommet de la tranchée (103) ; et
une couche barrière (600) située entre la première couche conductrice (200) et la première couche diélectrique (500), et s'étendant jusqu'au sommet de la première couche conductrice (200),
la couche diélectrique (300) étant également située sur des parois latérales de la tranchée (103) au-dessus de la première couche conductrice (200).
